# EUROPEAN PATENT APPLICATION

(11) **EP 0 762 815 A1**
(43) Date of publication of application: **12.03.1997**
(21) Application number: 96305621.3
(22) Date of filing: 31.07.1996
(51) Int. Cl.: H05K 5/00, H01M 2/10

(54) **Apparatus for mechanically interlocking two housings**

(30) Priority: 30.08.1995 US 520997
(71) Applicant: OHMEDA INC., Liberty Corner, New Jersey 07938-0804 (US)
(72) Inventor: Hunt, William Craig, Boulder, Colorado 80303 (US); Ward, Rodney Eugene, Longmont, Colorado 80501 (US)
(74) Representative: Gough, Peter

(57) **Abstract**

The mechanical interlock apparatus functions to securely interconnect two housings: an instrument module and a battery pack. The interlock apparatus comprises two sets of parallel-oriented spaced apart tabs formed as part of the housing on each of the instrument module and battery pack. The tabs are positioned and oriented to mate, thereby securing the battery pack to the instrument module. A locking mechanism is included to latch these two elements together once assembled. Several optional guiding mechanism can also be included to assist the user in attaching the battery pack to the instrument module.

## Description

This invention relates to medical monitoring apparatus and, in particular, to apparatus that functions to mechanically interlock two housings, a first one of which comprises a battery pack and a second one of which comprises a medical monitoring instrument module.

It is a problem in the field of battery operated apparatus to provide the user with ease of access to the batteries to replace the batteries when they are discharged. This is especially important when the batteries are rechargeable units and the associated device is a frequently used instrument. The rechargeable battery configuration should enable the user to remove quickly and simply the rechargeable batteries so that the entire unit is not taken out of service for an extended period of time simply to recharge the batteries, since the recharging cycle can take a significant amount of time.

Rechargeable batteries are either internally mounted within the instrument housing or externally mounted via some quick connect apparatus. The internally mounted batteries are the simplest to administer in terms of providing both a supporting enclosure and electrical interconnection to the batteries. The ease of management is due to the fact that the instrument housing provides an enclosing support and the interconnections are protected from the ambient environment. However, the internally mounted rechargeable batteries require an access opening in the housing, which opening enables contaminants to enter the equipment housing. The access opening is typically selected to be of minimum size to provide maximum rigidity and stability for the access opening cover. However, most internal battery mounts are cramped in terms of space and this makes the removal and replacement of batteries a difficult task. The internally mounted batteries also use a plurality of individual batteries, which can be inserted improperly or the charged and discharged batteries can be inadvertently intermixed. Thus, the internal mounting of batteries has problems which accompany its benefits.

External battery mounts are infrequently used due to the difficulty in providing an adequate means of securing the battery pack to the instrument and latching the battery once mounted. In addition, the electrical connections must be provided on the surface of the battery pack and are susceptible to damage if the user does not properly mount the battery pack to the instrument housing. The apparatus used to secure the battery pack to the instrument housing should be simple to use and foolproof. It is presently difficult to satisfy these requirements in a cost effective manner. For these reasons, external battery packs are not frequently used, and when used tend to be expensive implementations.

The above described problems are solved and a technical advance achieved in the field by the apparatus of the present invention for mechanically interlocking two housings.

According to the present invention an apparatus for releasably interconnecting a first component and a second component, each of which components comprises a housing that encloses elements which are to be interconnected by the apparatus, wherein said apparatus is operable to cause a first face of said housing of said first component to mate with a first face of said housing of said second component, said interconnecting apparatus comprises:
a plurality of tabs formed on said first face of said housing of said first component;
an equal number of tabs formed on said first face of said housing of said second component, positioned and oriented to mate with corresponding ones of said tabs formed on said first face of said housing of said first component; and
latch means located at an end of one of said first and said second components proximate said first face thereof for engaging a mating feature located on an end of a second one of said first and said second components proximate said first face thereof, for preventing movement of said first and second components with respect to each other when said latch means L is engaged.

In the preferred embodiment of the invention, the instrument module comprises a pulse oximeter instrument which is used to noninvasively measure the oxygen saturation of the haemoglobin contained in a patient's arterial blood. This instrument is obviously used in a hostile environment and is subject to exposure to numerous contaminants, some of which are extremely reactive. Thus, the instrument module must be a substantially sealed unit, impervious to the contaminants extant in the ambient environment. The instrument module cannot be removed from service for an extended period of time to recharge batteries and the battery replacement should therefore be speedy, and requiring little effort. The apparatus used to interconnect the battery pack to the instrument module must be relatively foolproof, so that a user can simply, unerringly remove the battery pack and mount a replacement battery pack, even in the user is wearing rubber gloves.

The apparatus illustrated in the preferred embodiment comprises two sets of elongated tabs, each set comprising two parallel oriented spaced apart rows of tabs formed on a respective one of the housings which enclose the instrument module and the battery pack. The tabs are positioned and oriented such that the tabs on the instrument module housing mate with corresponding tabs on the housing of the battery pack. To prevent the user from misaligning the tabs, there is provided at least one alignment pin on a one of the housings and corresponding slot(s) formed in the other housing so that the battery pack must be precisely positioned by means of the alignment pin(s) to enable the sets of tabs to be engaged. Once the pin(s) and slot(s) align, the entry of the pin(s) into the slot(s) enables the tabs to be aligned for engagement. The tabs are elongated elements which are aligned to form a tapered opening to receive a corresponding tab and, as the housings are laterally moved together, the tapered opening of the tabs increasingly forces the two housings into intimate contact.

A large projection may be included in one of the housings to accommodate large size circuit elements. The projection and its corresponding recess also enable the user to simply align the respective housings, since the projection and its receiving recess provide the user with visual and tactile feedback. Electrical contacts are provided on the two housings to enable the batteries in the battery pack to electrically interconnect with the equipment in the instrument module. The use of the plurality of tabs, pin/slot alignment features prevents the electrical contacts from being subject to damage, yet also provide a wiping action as the contacts slide over each other as the tabs seat.

Thus, the apparatus of the interlock mechanism securely attaches the battery pack to the instrument module in a simple foolproof manner. The number and placement of the tabs ensures that the two housings maintain the plastic housing substantially flat to prevent warping of the housing. The tabs uniformly draw the face of the housing of the battery pack against the mating face of the housing of the instrument module. These two mating faces should be substantially flush with each other to prevent the inclusion of contaminants between these two faces.

An embodiment of the invention will now be described, by way of example, reference being made to the Figures of the accompanying diagrammatic drawings in which:-
Figure 1 illustrates, in perspective view, a medical monitoring instrument that is equipped with a rechargeable battery pack, which instrument incorporates the mechanical interlock apparatus of the present invention;
Figure 2 illustrates, in perspective view, the face of the housing of the instrument module which incorporates the mechanical interlock apparatus of the present invention;
Figure 3 illustrates, in perspective view, the face of the housing of the battery pack which incorporates the mechanical interlock apparatus of the present invention; and
Figure 4 illustrates a side view of the tabs of the mechanical interlock apparatus of the present invention.

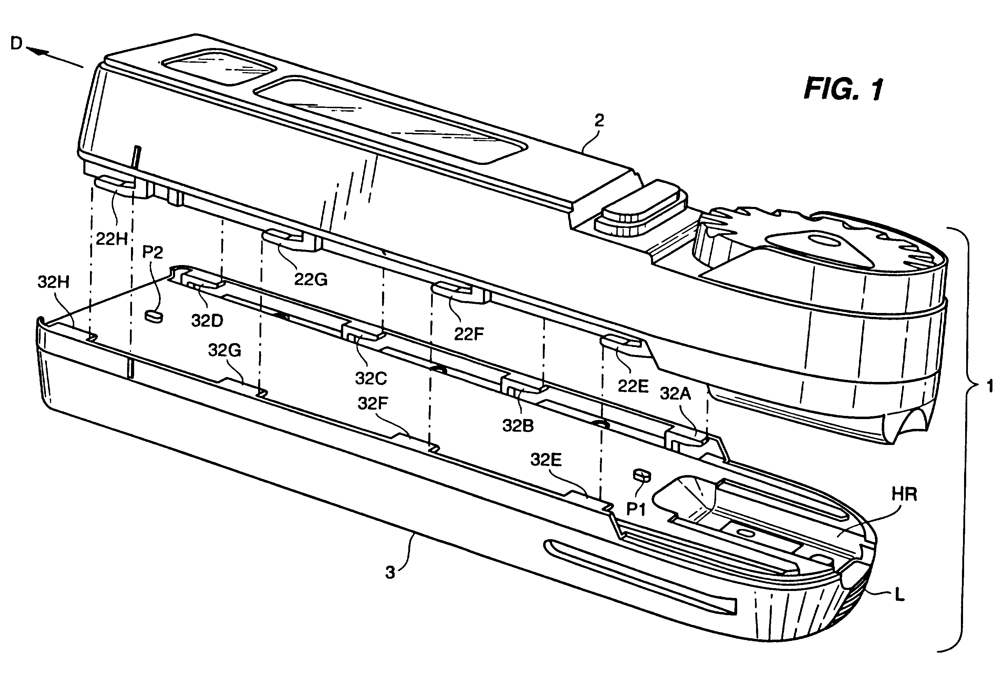

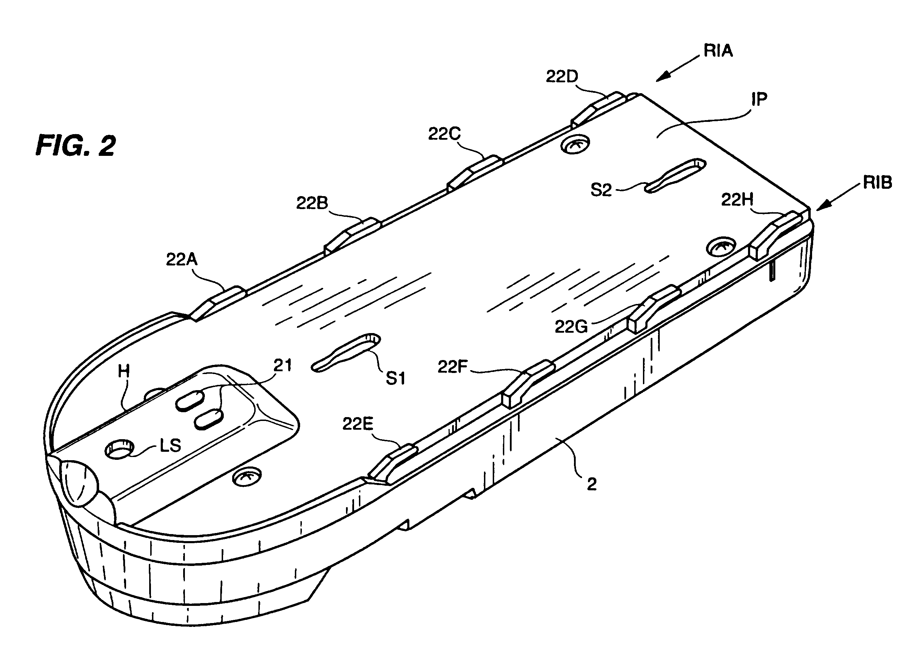

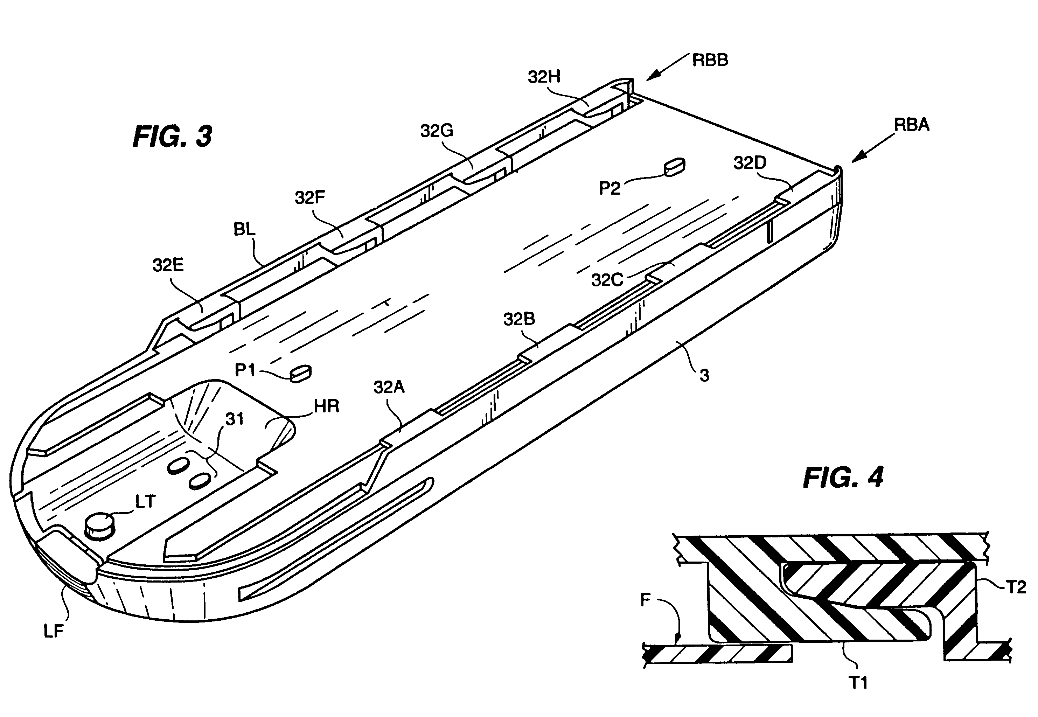

Figure 1 illustrates, in perspective view, a medical monitoring instrument 1, comprising an instrument module 2 that is equipped with a rechargeable battery pack 3, which instrument 1 incorporates the preferred embodiment of the mechanical interlock apparatus of the present invention. Figures 2 and 3 respectively illustrate, in perspective view, the face of the housing of the instrument module 2 and the face of the housing of the associated battery pack 3 which incorporate the preferred embodiment of the mechanical interlock apparatus of the present invention.

The instrument module 2 of the medical monitoring instrument 1 includes all the necessary electronics and controls to enable a user to activate and control the medical monitoring instrument 1 to perform its designed functions. The shape of the instrument module 2 illustrated in Figure 1 is substantially rectangular with rounded ends and edges, of dimensions to be ergonomically efficient. The instrument module 2 obtains its power from the associated battery pack 3 which comprises a housing inside of which are stored a plurality of rechargeable batteries. The electrical interconnection of the rechargeable batteries with the electronics of the instrument module 2 is accomplished by the use of a plurality of contacts 21, 31 which protrude from the housing of each of the instrument module 2 and the battery pack 3. These electrical contacts 21, 31 mate with each other when the instrument module 2 and the battery pack 3 are mechanically interconnected by the mechanical interlock apparatus of the present invention.

The preferred embodiment of the mechanical interlock apparatus of the preferred embodiment of the present invention comprises a plurality of parallel-oriented spaced apart tabs 22A-H, 32A-H formed on each of the instrument module 2 and the battery pack 3, which tabs 22A-H, 32A-H function to removably secure the battery pack 3 to the instrument module 2. The tabs 22A-H, 32A-H are aligned in two rows RIA, RIB, RBA, RBB on each of the instrument module 2 and the battery pack 3, substantially along the edges of the housing of each of these components. The two sets RBA, RBB of tabs 32A-H on the battery pack 3 are positioned and oriented to mate with the corresponding two sets RIA, RIB of tabs 22A-H on the instrument module 2.

The number of tabs 22A-H, 32A-H in each row is selected to maintain the plastic housing substantially flat to prevent warping of the housing. The number of tabs 22A-H, 32A-H is typically selected to also account for the possible loss of one or more tabs 22A-H, 32A-H. The tabs 22A-H, 32A-H are shown spaced substantially uniformly along at least a portion of the length of the housing of the instrument module 2 and the battery pack 3, although this particular spacing is not an absolute necessity. The tabs 22A-H, 32A-H should be of number, spacing and position to draw uniformly the face of the housing of the battery pack 3 against the mating face of the housing of the instrument module 2. These two mating faces should be substantially flush with each other to prevent the inclusion of contaminants between these two faces. In the preferred embodiment of the invention illustrated in Figures 1-3, there are four tabs 22A-H, 32A-H in each row, which number is sufficient to accomplish the stated purpose.

The configuration of tabs in two parallel oriented spaced apart rows is not the only configuration of tabs that performs the stated functions. The tabs can be oriented in any pattern, such as a three-point triangular configuration. In addition, if rows of tabs are used, they need not be parallel oriented. The specific size and shape of the medical monitoring instrument 1 lends itself to the use of the parallel oriented spaced apart rows of tabs, especially in view of the moulding process used to form the housings for the instrument module 2 and the battery pack 3. The selection of the number and configuration of tabs is typically a matter of design choice which results from many factors.

The shape of each tab (T1, T2 for example in Figure 4) is selected to have a long lead with a taper incorporated into the leading end portion of the tabs 22A-H, 32A-H. The taper comprises an angular orientation of the bearing surface of the tab T1, T2 with respect to the flat surface of the face F of the housing as well as a differential spacing between the load bearing surface of the tab T1, T2 and the face F of the housing surface. These two design components cause the mating sets of tabs 22A-H, 32A-H to initially loosely engage and, as the battery pack and instrument module are moved laterally (direction D in Figure 1) into the locking position, forces the two elements into intimate contact. This guiding function causes the tabs 22A-H, 32A-H to lock together and precisely positions the battery pack 3 on the instrument module 2.

The tabs 22A-H, 32A-H are implemented in a manner to ensure strength of the tabs 22A-H, 32A-H and to prevent damage to the tabs 22A-H, 32A-H. In particular, the tabs 22A-H formed on the housing of the instrument module 2 are implemented as part of the body of the housing. A plateau IP region is formed on the mating face of the housing of the instrument module 2, with a narrow shelf remaining along the two long sides of this face. The tabs 22A-H are formed as part of the plateau region IP, extending into the shelf region. One side of each tab 22A-H is integral to the plateau region to thereby provide integral support to the end of each tab 22A-H. The battery pack 3 has a mating set of tabs 32A-H formed in an inverse manner. In particular, the mating face of the housing of battery pack 3 includes a lip BL formed along the two long sides of this face. The tabs 32A-H are formed as part of the lip BL, extending into the region between the two lips BL. One side of each tab 32A-H is integral to the lip BL to thereby provide integral support to the end of each tab 32A-H.

The housings of the battery pack 3 and the instrument module 2 include an additional guide feature comprising at least one pin P1, P2 and bottle-shaped mating slot S1, S2, which are located substantially in the centre (with respect to the sides) of the respective mating faces of the housings. This guide feature P1, P2, S1, S2 ensures that the proper ones of tabs 22A-H, 32A-H engage by preventing the user from laterally mispositioning the instrument module 2 with respect to the battery pack 3. In addition, the necked down portion of the slot(s) S1, S2 impairs any side-to-side movement of the instrument module 2 with respect to the battery pack 3. In addition, the lip LP formed on the housing of the battery pack 3 and the interior plateau IP formed on the instrument module 2 form a channel when the instrument module 2 and battery pack 3 are placed together. This channel is of width that accepts the tabs 22A-H, 32A-H and yet prevents side-to-side movement of the tabs 22A-H, 32A-H within the channel. This channel simplifies the alignment of the instrument module 2 and battery pack 3, and prevents a user from improperly aligning these two elements. Thus, the combination of tabs 22A-H, 32A-H, the channel formed by the two housings, and the guide elements P1, P2, S1, S2 ensure simple, accurate, failure proof attachment of the battery pack 3 to the instrument module 2.

The hump H shown in Figure 3, at one end of the instrument module 2 is formed to enable the placement of large size components in the instrument module 2 but, with the mating recess HR, also serves as visual and tactile feedback to the user to assist the user in positioning the two components (instrument module 2 and battery pack 3) together prior to engaging the tabs 22A-H, 32A-H.

A locking mechanism L is provided at one end of the battery pack 3 to secure the two components together once the tabs 22A-H, 32A-H are fully engaged. The locking mechanism L comprises a snap fit spring loaded tab LT located on the battery pack 3 which engages a mating slot LS in the instrument module 2. The locking tab LT and slot LS are both located at an end of the respective housings located proximate to the mating face of the housings. To disengage the two components, the user operates a projection LF on the locking tab LT to release the locking tab LT from its locking slot LS in the instrument module 2. This locking release mechanism is easy to operate and functions to release automatically the battery pack 3 from the instrument module 2 if the medical monitoring instrument 1 is dropped. The impact of the medical monitoring instrument 1 on a hard surface will, in most instances, cause the locking tab release to operate, thereby enabling the battery pack 3 to separate from the instrument module 2. The separation of these two components reduces the chance for injury to the instrument module 2 caused by the mass of the battery pack 3.

The housings as well as the tabs 22A-H, 32A-H are moulded in a single operation from the industry standard PCABS material. The tabs 22A-H, 32A-H are moulded into the respective housing edges, with one side of each tab 22A-H, 32A-H being a continuum of the housing. Thus, there are no "hanging edges" on the tabs 22A-H, 32A-H, which reduces the possibility of damage to the ends of the tabs 22A-H, 32A-H.

## Claims

1. An apparatus for releasably interconnecting a first component 2 and a second component 3, each of which components comprises a housing that encloses elements which are to be interconnected by the apparatus, wherein said apparatus is operable to cause a first face of said housing of said first component 2 to mate with a first face of said housing of said second component 3, said interconnecting apparatus comprising:
a plurality of tabs 22 formed on said first face of said housing of said first component 2;
an equal number of tabs 32 formed on said first face of said housing of said second component 3, positioned and oriented to mate with corresponding ones of said tabs 22 formed on said first face of said housing of said first component 2; and
latch means L located at an end of one of said first and said second components 2, 3 proximate said first face thereof for engaging a mating feature located on an end of a second one of said first and said second components 2, 3 proximate said first face thereof, for preventing movement of said first and second components with respect to each other when said latch means L is engaged.

2. An apparatus as claimed in Claim 1 wherein each of said tabs 22 formed on said first face of said housing of said first component 2 comprises:
an elongated projection which is attached at a one end thereof to said housing of said first component 2 to form a channel between said elongated projection and said housing of said first component 2 for accepting a corresponding one of said tabs 32 formed on said first face of said housing of said second component 3.

3. An apparatus as claimed in Claim 2 wherein each of said tabs 22 formed on said first face of said housing of said first component 2 is also connected along substantially the entirety of a length of said elongated projection to said housing of said first component 2.

4. An apparatus of Claim 2 wherein said channel formed between said elongated projection and said housing of said first component 2 is tapered along its length such that the distance between said elongated projection and said housing of said first component 2 is greater at an end of said elongated projection distal from said end at which said elongated projection is attached to said housing than at said end at which said elongated projection is attached to said housing.

5. An apparatus as claimed in any one of Claims 1 to 4 wherein each of said tabs 32 formed on said first face of said housing of said second component 3 comprises:
an elongated projection which is attached at a one end thereof to said housing of said second component 3 to form a channel between said elongated projection and said housing of said second component for accepting a corresponding one of said tabs 22 formed on said first face of said housing of said first component 2.

6. An apparatus as claimed in Claim 5 wherein each of said tabs 32 formed on said first face of said housing of said second component 3 is also connected along substantially the entirety of a length of said elongated projection to said housing of said second component 3.

7. An apparatus as claimed in Claim 5 wherein said channel formed between said elongated projection and said housing of said second component 3 is tapered along its length such that the distance between said elongated projection and said housing of said second component 3 is greater at an end of said elongated projection distal from said end at which said elongated projection is attached to said housing than at said end at which said elongated projection is attached to said housing.

8. An apparatus as claimed in any one of Claims 1 to 7 further comprising alignment means comprising:
a projection P formed on said first face of said housing of a first one of said first and second components; and
a slot S formed in said first face of said housing of a second one of said first and second components of dimensions and position to mate with said projection.

9. An apparatus as claimed in Claim 8 wherein said slot S is elongated in shape along a length dimension of said face of said housing of a second one of said first and second components to enable said projection to move laterally along said length dimension as said first component and said second component are moved laterally to engage said tabs located on said first face of said housing of each of said first and second components.

10. An apparatus as claimed in Claim 8 or 9 wherein said projection P is located substantially centred between adjacent sides of said face of said housing of a first one of said first and second components.

11. An apparatus as claimed in any one of Claims 1 to 10 wherein said tabs 22, 32 formed on said first face of each of said first and second components are located in two substantially parallel spaced apart rows.

12. An apparatus as claimed in Claim 11 wherein said tabs formed on said first face of said housing of said first component 2, are spaced apart in a substantially uniform spacing in said two substantially parallel spaced apart rows; and said tabs formed on said first face of said housing of said second component 3, are spaced apart in a substantially uniform spacing in said two substantially parallel spaced apart rows.
